# EUROPEAN PATENT APPLICATION

(11) **EP 4 608 117 A1**
(43) Date of publication of application: **27.08.2025**
(21) Application number: 23879518.1
(22) Date of filing: 14.09.2023
(51) Int. Cl.: H10N 60/82, G01J 1/02, H01L 31/08

(54) **SUPERCONDUCTING STRIP DETECTOR AND METHOD FOR MANUFACTURING SUPERCONDUCTING STRIP USED THEREIN**

(30) Priority: 21.10.2022 JP 2022168777
(71) Applicant: National Institute of Information and Communications Technology, Koganei-shi, Tokyo 184-8795 (JP)
(72) Inventor: YABUNO, Masahiro, Tokyo 184-8795 (JP); MIKI, Shigehito, Tokyo 184-8795 (JP); TERAI, Hirotaka, Tokyo 184-8795 (JP)
(74) Representative: Witte, Weller & Partner Patentanwälte mbB
(86) International application number: PCT/JP2023/033492
(87) International publication number: WO 2024/084868

(57) **Abstract**

A superconducting strip detector includes a superconducting strip located on a detection zone where a detection target having a significant energy is to be detected, and detects the detection target in the detection zone by bringing the superconducting strip into a superconducting state and applying a bias current to the superconducting strip through a predetermined bias current path. The superconducting strip includes a wire portion in which a critical current value per unit length in a width direction of the superconducting strip is higher in opposite end portions of a width of the wire portion than in a central portion of the width of the wire portion.

## Description

### Technical Field

The present invention relates to a superconducting strip detector and a method of producing a superconducting strip for use in the superconducting strip detector.

### Background Art

For example, superconducting strip detectors are known which detect detection targets such as photons, electrons, molecules, and radial rays. For example, superconducting single photon detectors (hereinafter sometimes abbreviated as SSPDs) for detection of single photons are expected to be used as high-sensitivity, low-noise, high-speed-operating single photon detectors in various fields such as quantum information communication and quantum optics (see Non-Patent Literatures 1 and 2, for example). Detection devices used in SSPDs to detect single photons are wire-shaped light receivers (hereinafter referred to as superconducting strips) which are located on predetermined detection zones. The superconducting strips are called nanostrips or nanowires, a known example of which is a niobium nitride wire made of niobium nitride (NbN), having a width of around 100 nm, and used in a superconducting state. An SSPD employing such a nanostrip is also called a superconducting nanostrip single photon detector (SNSPD). Systems developed with the use of SNSPDs are superior in performance to semiconductor detectors and thus are becoming increasingly used in diverse fields of advanced technologies such as in quantum cryptography key distribution tests, verification tests for various quantum information technologies, and biomedical applications.

It has recently been discovered that single photons can be detected by using a superconducting strip having a width of more than 1 µm (called a microstrip, microwire, or microbridge) instead of a nanostrip (see Non-Patent Literature 3, for example). An SSPD employing such a microstrip is called a superconducting microstrip single photon detector (SMSPD). In the case of SNSPDs the superconducting strip needs to be formed by electron lithography, while in the case of SMSPDs the superconducting strip can be formed by optical lithography; thus, SMSPDs can be manufactured with considerably improved uniformity of device performance and much increased mass productivity. If the superconducting strip has a width of, for example, more than 10 µm which is sufficiently greater than the focused spot diameter of incident photons, the filling factor of the light-receiving region relative to the focused spot diameter can be 100%, and this is expected to lead to high quantum efficiency.

As such, SMSPDs are attracting global attention as a crucial technology for realizing quantum networks, quantum internet, and quantum computers which are predicted to necessitate a huge number of sophisticated photon detectors due to sophistication and scale-up of the systems.

### Citation List

### Non-Patent Literature

NPL 1: M. Sasaki, M. Fujiwara, H. Ishizuka, W. Klaus, K. Wakui, M. Takeoka, S. Miki, T. Yamashita, Z. Wang, A. Tanaka, K. Yoshino, Y. Nambu, S. Takahashi, A. Tajima, A. Tomita, T. Domeki, T. Hasegawa, Y. Sakai, H. Kobayashi, T. Asai, K. Shimizu, T. Tokura, T. Tsurumaru, M. Matsui, T. Honjo, K. Tamaki, H. Takesue, Y. Tokura, J. F. Dynes, A. R. Dixon, A. W. Sharpe, Z. L. Yuan, A. J. Shields, S. Uchikoga, M. Legre, S. Robyr, P. Trinkler, L. Monat, J. B. Page, G. Ribordy, A. Poppe, A. Allacher, O. Maurhart, T. Langer, M. Peev, and A. Zeilinger, "Field test of quantum key distribution in the Tokyo QKD Network", Opt. Express 19, 10387 (2011).
NPL 2: T. Kobayashi, R. Ikuta, S. Yasui, S. Miki, T. Yamashita, H. Terai, T. Yamamoto, M. Koashi, and N. Imoto, "Frequency-domain Hong-Ou-Mandel interference", Nature Photonics 10, 441 (2016).
NPL 3: Y. P. Korneeva, D. Yu. Vodolazov, A. V. Semenov, I. N. Florya, N. Simonov, E. Baeva, A. A. Korneev, G. N. Goltsman, T. M. Klapwijk, "Optical Single-Photon Detection in Micrometer-Scale NbN Bridges", Phys. Rev. Applied 9, 064037 (2018)

### Summary of Invention

### Technical Problem

In SNSPDs, the superconducting strip has a width of around 100 nm. Thus, in order to form a light-receiving surface having a given area which is, for example, 15 µm × 15 µm, the nanostrip needs to be formed in a suitable shape such as a meandering shape for filling a detection zone having the given area. For this reason, the realization of SNSPDs necessarily requires a sophisticated nanopattern formation technology.

In SMSPDs, the superconducting strip is wider than in SNSPDs. This makes it possible to form a light-receiving surface having a given area without having to form the superconducting strip in a complicated shape. However, an increase in the width of the superconducting strip unfortunately entails an increase in the occurrence of dark count, a phenomenon in which a detection signal is outputted despite the absence of any incident photons. SNSPDs could also suffer from dark count although the occurrence of dark count in SNSPDs is relatively low. Dark count could occur also in other types of superconducting strip detectors for detecting detection targets other than single photons, such as multiphotons, electrons, molecules, neutrons, and radial rays.

The present invention has been made to solve the problem as described above, and an object of the present invention is to provide a superconducting strip detector adapted to reduce the occurrence of dark count and a method of producing a superconducting strip for use in the superconducting strip detector.

### Solution to Problem

A superconducting strip detector according to one aspect of the present invention is a superconducting strip detector including a superconducting strip located on a detection zone where a detection target having a significant energy is to be detected, wherein
the superconducting strip detector detects the detection target in the detection zone by bringing the superconducting strip into a superconducting state and applying a bias current to the superconducting strip through a predetermined bias current path,
the superconducting strip includes a wire portion in which a critical current value per unit length in a width direction of the superconducting strip is higher in opposite end portions of a width of the wire portion than in a central portion of the width of the wire portion.

A method of producing a superconducting strip for use in a superconducting strip detector according to another aspect of the present invention is a method of producing a superconducting strip for use in a superconducting strip detector that includes the superconducting strip located on a detection zone where a detection target having a significant energy is to be detected and that detects the detection target in the detection zone by bringing the superconducting strip into a superconducting state and applying a bias current to the superconducting strip through a predetermined bias current path, the method including:
forming the superconducting strip such that the superconducting strip includes a wire portion in which a critical current value per unit length in a width direction of the superconducting strip is higher in opposite end portions of a width of the wire portion than in a central portion of the width of the wire portion.

### Advantageous Effects of Invention

The present invention can reduce the occurrence of dark count.

### Brief Description of Drawings

FIG. 1 is a plan view schematically showing one example of the configuration of a superconducting strip detector of one embodiment according to the present invention.
FIG. 2 shows a critical current value distribution in the width direction of a superconducting strip shown in FIG. 1.
FIG. 3 shows a first example of a superconducting strip production method of the present embodiment.
FIG. 4 shows a second example of the superconducting strip production method of the present embodiment.
FIG. 5 shows a third example of the superconducting strip production method of the present embodiment.
FIG. 6 shows a fourth example of the superconducting strip production method of the present embodiment.
FIG. 7 shows a fifth example of the superconducting strip production method of the present embodiment.
FIG. 8 shows a critical current value distribution in the width direction of a conventionally-structured superconducting strip.
FIG. 9 illustrates some conditions of a superconducting strip which are responsible for the occurrence of dark count; FIG. 9A is a cross-sectional view showing the superconducting strip with chipped edges, FIG. 9B is a cross-sectional view showing the superconducting strip having rough side surfaces, and FIG. 9C is a plan view showing the superconducting strip having a non-uniform width.

### Description of Embodiments

Hereinafter, an embodiment of the present invention will be described with reference to the drawings. The same or equivalent elements are denoted by the same reference signs throughout the drawings, and repeated explanation of such elements may be omitted.

The present invention is not limited to the embodiment described below. That is, the following detailed description is merely given to illustrate the features of the "superconducting strip detector" of the present invention. In the following description, when a term referring to an element for defining the "superconducting strip detector" of the present invention is used with an attached reference sign to describe a specific example, the specific device described is an example of the corresponding element of the "superconducting strip detector" of the present invention.

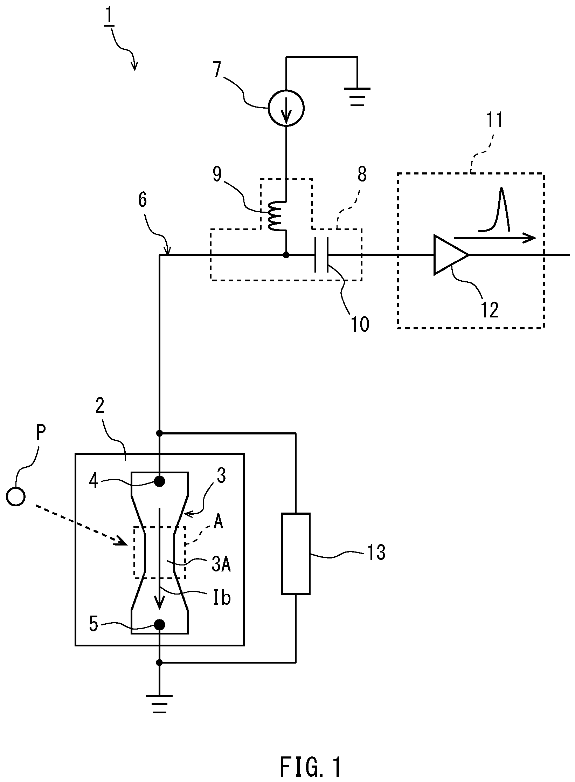

FIG. 1 is a plan view schematically showing one example of the configuration of a superconducting strip detector of one embodiment according to the present invention. In the example of FIG. 1, the superconducting strip detector is illustrated by way of example as a superconducting single photon detector which detects single photons. The superconducting single photon detector (SSPD) 1 of the present embodiment includes a substrate 2 and a superconducting strip 3 located on a predetermined detection zone A of the substrate 2 and used in a superconducting state. The two-dimensional size of the detection zone A is defined according to the intended use of the superconducting single photon detector 1. For example, the detection zone A is shaped as a square 15 to 50 µm on a side.

In the present embodiment, the superconducting strip 3 is formed in a linear shape in the detection zone A. Thus, when, for example, the detection zone A is shaped as a square 15 µm on a side, the superconducting strip 3 includes a wire portion 3A lying in the detection zone A and having a width of, for example, 10 to 15 µm in order to cover all or nearly all of the detection zone A.

The superconducting strip 3 is cooled by any suitable cooling means (e.g., a Gifford-McMahon refrigerator) and used in a superconducting state. The superconducting strip 3 is made of, for example, niobium nitride (NbN). The thickness of the superconducting strip 3 is, for example, from 5 to 10 nm. The substrate 2 is, for example, a silicon (Si) substrate.

The superconducting strip 3 is connected to electrodes 4 and 5 outside the detection zone A. The first electrode 4 is connected to a transmission path 6, and the second electrode 5 is connected to the ground. The superconducting strip 3 is connected to a bias current source 7 via the transmission path 6, and a given bias current Ib lower than a superconducting critical current is applied from the bias current source 7 to the superconducting strip 3. A shunt resistor 13 is interposed between the electrodes 4 and 5. The shunt resistor 13 need not necessarily be used. In order to prevent the superconducting state from being broken at points where the electrodes 4 and 5 and the transmission path 6 are connected to the superconducting strip 3, the electrodes 4 and 5 and the transmission path 6 are preferably made of the same material as the superconducting strip 3.

When a photon (single photon) P is incident on the light receiving surface (the wire portion 3A in the detection zone A) of the superconducting strip 3, the energy provided by the photon P exceeds a gap energy, and accordingly the superconducting strip 3 goes through some physical processes to undergo a change in resistance or inductance. The change in resistance or inductance is detected through the transmission path 6.

To this end, in the present embodiment, the SSPD 1 includes a bias tee 8 interposed between the transmission path 6 and the bias current source 7. In general, the bias tee 8 includes an inductor 9 and a capacitor 10. The bias tee 8 includes a T-shaped wire having three ends. The bias current source 7 is connected to a first end of the three ends via the inductor 9, the transmission path 6 is connected to a second end of the three ends, and an output circuit 11 is connected to a third end of the three ends via the capacitor 10. The output circuit 11 includes an amplifier 12, by which the output circuit 11 amplifies a voltage signal transmitted through the transmission path 6 and from which the output circuit 11 outputs the amplified voltage signal. The amplifier 12 is not used in some cases.

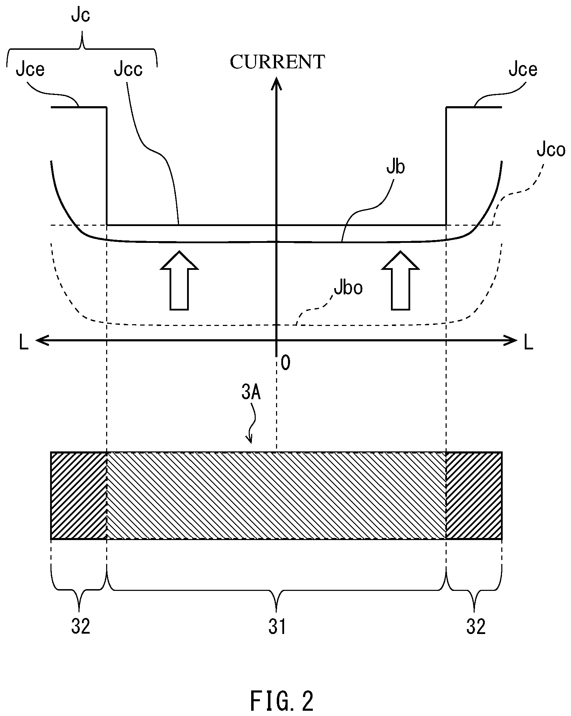

FIG. 2 shows a critical current value distribution in the width direction of the superconducting strip shown in FIG. 1. In FIG. 2, the critical current value distribution in the width direction is shown along with the superconducting strip 3 as viewed in a cross-section perpendicular to the direction of the bias current Ib flowing through the wire portion 3A of the superconducting strip 3. In this example, the direction of the bias current Ib flowing through the wire portion 3A coincides with the longitudinal direction of the wire portion 3A. In the present embodiment, the wire portion 3A includes a wire portion in which the critical current value per unit length in the width direction is higher in the opposite end portions of its width than in the central portion of its width. In the present embodiment, the wire portion 3A of the superconducting strip 3 includes: a central region 31 in which the critical current value per unit length in the width direction is a first value; and side regions 32 in which the critical current value per unit length in the width direction is a second value higher than the first value.

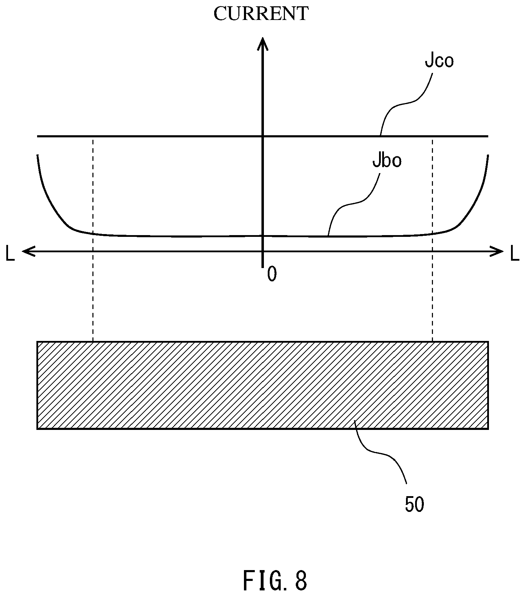

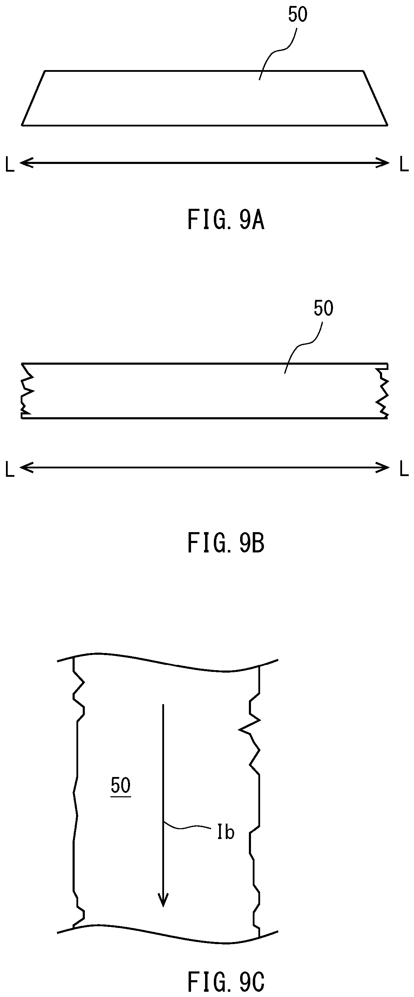

To describe the structure of the wire portion 3A of the superconducting strip 3 of the present embodiment, the disadvantage of a superconducting strip in which the critical current value per unit length in its width direction is uniform everywhere will be described first. FIG. 8 shows a critical current value distribution in the width direction of a conventionally-structured superconducting strip. FIG. 9 illustrates some conditions of the superconducting strip which are responsible for the occurrence of dark count.

FIG. 8 shows the conventionally-structured superconducting strip 50 in a cross-section perpendicular to the longitudinal direction of the conventionally-structured superconducting strip 50 (the direction in which the bias current Ib flows) and depicts a graph showing a bias current distribution Jbo with respect to a width direction distance L from the center of the width of the superconducting strip 50. The conventionally-structured superconducting strip 50 is made of a homogeneous material (a material in which the critical current density is the same everywhere) and formed to have a constant thickness. Thus, the critical current value Jco per unit length in the width direction of the superconducting strip 50 is constant regardless of the width direction distance L.

Application of the bias current Ib to the conventionally-structured superconducting strip 50 as described above is predicted to produce a current distribution Jbo in which the bias current Ib is concentrated in the opposite end portions of the width of the superconducting strip 50. The trend of such a current distribution Jbo (the degree of concentration of the bias current in the opposite width end portions) becomes more evident with increasing width of the superconducting strip 50 and increasing amount of the bias current. Thus, an increase in the amount of the bias current supplied to the superconducting strip 50 brings the amount of the bias current flowing through the opposite end portions of the width of the superconducting strip 50 closer to the critical current value Jco per unit length in the width direction. This means that the amount of the bias current flowing through the opposite end portions of the width of the superconducting strip 50 is more likely to become close to the critical current value Jco per unit length in the width direction than the amount of the bias current flowing through the central portion of the width of the superconducting strip 50. That is, the ratio Jbo/Jco is more likely to become close to 1. The closer the amount of the bias current flowing through the opposite end portions of the width of the superconducting strip 50 is to the critical current value Jco per unit length in the width direction, the weaker the superconductivity of the opposite end portions of the width of the superconducting strip 50 becomes. In addition, a magnetic flux (called a vortex or a vortex filament) becomes more likely to enter the superconducting strip 50 from its edge portions. Hence, dark count is likely to occur in the edge portions of the superconducting strip 50. This is one possible reason why the greater the width of the superconducting strip 50 is, the more likely dark count is to occur. Furthermore, the fact that the amount of the bias current in the opposite width end portions (the current value in the opposite width end portions in the bias current distribution Jbo) is greater than the amount of the bias current in the width central portion (the current value in the width central portion in the bias current distribution Jbo) makes it difficult to apply a sufficient amount of bias current to the width central portion, leading to a limited detection efficiency.

As shown in FIG. 9, the edge portions of the superconducting strip 50 can have a non-uniform shape resulting from the device fabrication process. For example, FIG. 9A is a cross-sectional view showing the superconducting strip 50 with chipped edges. The edge chipping causes a non-uniform thickness of the superconducting strip 50. FIG. 9B is a cross-sectional view showing the superconducting strip 50 having rough side surfaces. FIG. 9C is a plan view showing the superconducting strip 50 having a non-uniform width.

The illustrated conditions of the superconducting strip 50 can weaken the superconductivity of the opposite end portions of the width of the superconducting strip 50. When the edge portions of the superconducting strip 50 have any of the illustrated shapes, a magnetic flux (called a vortex or a vortex filament) is likely to enter the superconducting strip 50 from its edge portions. Along with the flow of the bias current, the magnetic flux crosses the superconducting strip 50 to break the superconducting state. In consequence, dark count occurs. Thus, the shape non-uniformity of the edge portions of the superconducting strip 50 is believed to be one of the causes of dark count.

The inventors conducted a thorough study based on the above-described analysis on the bias current distribution in the width direction and the causes of dark count. Given that dark count is likely to occur when the superconductivity of the edge portions of the wire portion 3A of the superconducting strip 3 is weakened compared to the superconductivity of the central portion of the wire portion 3A, the inventors have come up with the idea of reducing the weakening effect on the superconductivity of the edge portions (the opposite end portions of the width) of the wire portion 3A of the superconducting strip 3 by forming the wire portion 3A of the superconducting strip 3 such that the wire portion 3A includes a wire portion in which the critical current value per unit length in the width direction is higher in the opposite end portions of its width than in the central portion of its width, and have found that the reduction of the superconductivity weakening effect can lead to reduced occurrence of dark count and improved detection efficiency.

FIG. 2 shows a cross-sectional view of the wire portion 3A of the superconducting strip 3 of the present embodiment and a graph showing a critical current value Jc per unit length in the width direction with respect to the width direction distance L from the center (L = 0) of the width of the wire portion 3A. In the present embodiment, the critical current value per unit length in the width direction is a first value Jcc in the central region 31 and is a second value Jce higher than the first value Jcc in the side regions 32.

In the present embodiment, the critical current value per unit length in the width direction is higher in the side regions 32 of the wire portion 3A than in the central region 31 of the wire portion 3A. That is, the superconductivity of the side regions 32 is stronger than the superconductivity of the central region 31. This can make the superconducting state of the superconducting strip 3 less likely to be broken upon application of the bias current Ib to the superconducting strip 3, even when the amount of the bias current is greater in the edge portions (i.e., the side regions 32) of the wire portion 3A than in the central region 31 of the wire portion 3A. In addition, the enhancement of the superconductivity of the side regions 32 can reduce the decline in superconductivity of the edge portions of the wire portion 3A. Furthermore, the enhancement of the superconductivity of the side regions 32 can reduce the decline in superconductivity stemming from the shape non-uniformity of the edge portions of the wire portion 3A.

The reduction in the decline in superconductivity of the edge portions can lead to reduced occurrence of dark count. The reduced occurrence of dark count makes it possible to increase the width of the wire portion 3A or raising the ambient temperature without sacrifice of the detection performance.

Furthermore, the bias current Ib supplied to the central region 31 of the wire portion 3A can have a higher value than the bias current Ib supplied to the conventionally-structured superconducting strip 50. For example, as shown in FIG. 2, the critical current value (first value Jcc) per unit length in the width direction in the central region 31 of the wire portion 3A is equal to the critical current value Jco per unit length in the width direction in the conventionally-structured superconducting strip 50, and the critical current value (second value Jce) per unit length in the width direction in the side regions 32 of the wire portion 3A is higher than the critical current value Jco per unit length in the width direction in the conventionally-structured superconducting strip 50.

In this case, as indicated by the upward block arrows in the graph of FIG. 2, the bias current value in the side regions 32 is unlikely to exceed the critical current value Jc per unit length in the width direction even upon application of the bias current Ib (bias current having the current distribution Jb shown in FIG. 2) having a higher current value than the bias current Ib (bias current having the current distribution Jbo) the application of which to the conventionally-structured superconducting strip 50 is likely to cause dark count. Thus, the bias current value in the central region 31 can be brought closer to the critical current value (first value Jcc) per unit length in the width direction than in the conventional structure.

The fact that the bias current value in the central region 31 can be brought close to the critical current value (first value Jcc) per unit length in the width direction allows for an improvement in the photon detection efficiency and jitter properties (temporal resolution) exhibited upon incidence of the photon P on the central region 31.

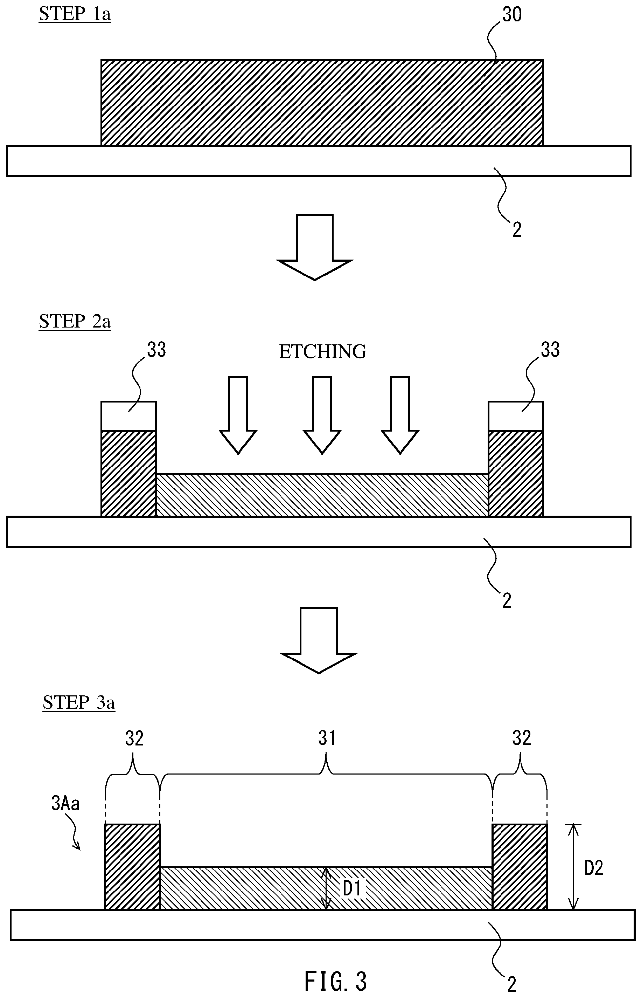

The following will describe examples of the method of producing the superconducting strip 3 of the present embodiment. FIG. 3 shows a first example of the superconducting strip production method of the present embodiment. In FIG. 3, the steps are shown using cross-sectional views perpendicular to the direction in which the bias current flows through the formed superconducting strip 3. First, in step 1a, a wire layer 30 having a given wire shape is formed on a substrate 2. The wire layer 30 is formed using a homogeneous material so as to have a constant thickness. The wire layer 30 formed in step 1a has the same structure as the conventionally-structured superconducting strip 50 described above.

Next, in step 2a, a mask 33 such as a resist is formed on each of the opposite end portions of the width of that region of the wire layer 30 which corresponds to a wire portion 3Aa, and the wire layer 30 is subjected to etching. The etching may be either dry etching or wet etching. In step 3a, the mask 33 is removed, and thus the wire portion 3Aa of the superconducting strip 3 is formed. The thinned portion resulting from the etching is the central region 31, and the unetched portions protected by the mask 33 (the portions whose thickness remains unchanged) are the side regions 32.

The wire portion 3Aa thus produced includes the central region 31 having a first thickness D1 and the side regions 32 respectively adjacent to the opposite end portions of the width of the central region 31 and having a second thickness D2 greater than the first thickness D1. The wire portion 3Aa of the present example has the same critical current density both in the central region 31 and the side regions 32. However, since the side regions 32 are thicker than the central region 31, the critical current value per unit length in the width direction is higher in the side regions 32 than in the central region 31. That is, the side regions 32 have stronger superconductivity than the central region 31.

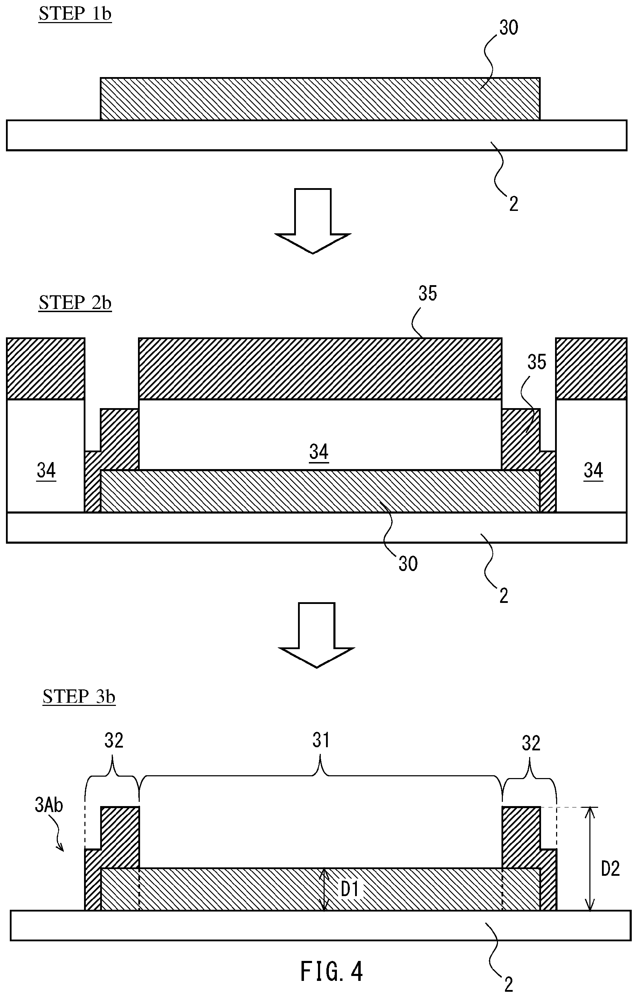

FIG. 4 shows a second example of the superconducting strip production method of the present embodiment. Also in FIG. 4, the steps are shown using cross-sectional views perpendicular to the direction in which the bias current flows through the formed superconducting strip 3. First, in step 1b, a wire layer 30 having a given wire shape is formed on a substrate 2 as in the first example.

Next, in step 2b, a mask 34 such as a resist is formed on the substrate 2 and the central portion of the width of that region of the wire layer 30 which corresponds to a wire portion 3Ab, and then an additional layer 35 made of the same material as the wire layer 30 is deposited. In step 3b, the mask 34 is removed, and thus the wire portion 3Ab of the superconducting strip 3 is formed. In the wire portion 3Ab, the thickened portions including the additional layer 35 remaining on those opposite end portions of the width of the wire layer 30 which are not covered by the mask 34 are the side regions 32, and the portion with no remaining additional layer 35 is the central region 31.

Like the wire portion of the first example, the wire portion 3Ab produced in the present example includes the central region 31 having a first thickness D1 and the side regions 32 respectively adjacent to the opposite end portions of the width of the central region 31 and having a second thickness D2 greater than the first thickness D1. The wire portion 3Ab of the present example has the same critical current density both in the central region 31 and the side regions 32. However, since the side regions 32 are thicker than the central region 31, the critical current value per unit length in the width direction is higher in the side regions 32 than in the central region 31. That is, the side regions 32 have stronger superconductivity than the central region 31.

In the example of FIG. 4, the mask 34 is formed so as not to cover the edge portions of the wire layer 30. Thus, there are regions which are outside the opposite end portions of the width of the wire layer 30 and in which the additional layer 35 is formed on the substrate 2. Hence, the side regions 32 of the wire portion 3Ab which are obtained by removal of the mask 34 include regions having a thickness smaller than the second thickness D2. However, the thickness of each side region 32 as a whole is greater than the first thickness D1. The formation of the additional layer 35 outside the opposite end portions of the width of the wire layer 30 can reduce the decline in superconductivity stemming from the shape non-uniformity of the edge portions which is as described above with reference to FIGS. 9A to 9C.

Alternatively, the formation of the additional layer 35 may be done such that the additional layer 35 is not formed on the substrate 2 outside the opposite end portions of the width of the wire layer 30. In this case, the side regions 32 formed include no stepped portions and thus can have a uniform second thickness D2.

In the present example, the additional layer 35 is made of the same material as the wire layer 30. Alternatively, the additional layer 35 may be made of a material having superconductivity and different from the material of the wire layer 30. In the present example, the additional layer 35 is illustrated as being formed in contact with the wire layer 30. Alternatively, another layer such as an insulator layer may be located between the wire layer 30 and the additional layer 35. That is, each of the side regions 32 may include a first superconducting material layer having the same thickness as the central region 31 and a second superconducting material layer located in proximity to the first superconducting material layer. In this case, the other layer lying between the first and second superconducting material layers is not limited to having a particular thickness and may have any thickness so long as a tunnel current can flow between the first and second superconducting material layers.

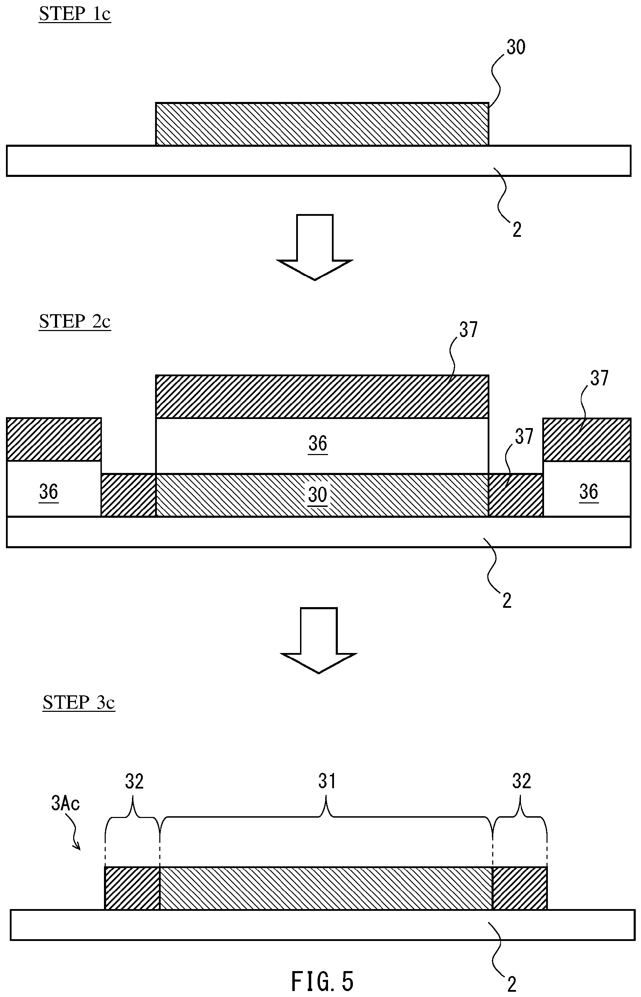

FIG. 5 shows a third example of the superconducting strip production method of the present embodiment. Also in FIG. 5, the steps are shown using cross-sectional views perpendicular to the direction in which the bias current flows through the formed superconducting strip 3. First, in step 1c, a wire layer 30 having a given wire shape is formed on a substrate 2 as in the first example. The width of that region of the formed wire layer 30 which corresponds to a wire portion 3Ac is smaller than the width of the finally-formed wire portion 3Ac (and equal to the width of the central region 31).

Next, in step 2c, a mask 36 is formed on the substrate 2 and the wire layer 30, except those regions of the substrate 2 which correspond to the side regions 32 of the wire portion 3Ac, and then a second material layer 37 is deposited. The second material layer 37 is made of a second material having a higher critical current density than a first material of which the wire layer 30 is made. In the present example, the second material layer 37 has the same thickness as the wire layer 30.

In step 3c, the mask 36 is removed, and thus the wire portion 3Ac of the superconducting strip 3 is formed. As such, the wire portion 3Ac of the present example includes the central region 31 made of the first material having a first critical current density and the side regions 32 respectively adjacent to the opposite end portions of the width of the central region 31 and made of the second material having a second critical current density higher than the first critical current density. Even though the central region 31 and the side regions 32 have the same thickness, the critical current value per unit length in the width direction differs between the central region 31 and the side regions 32 since the central region 31 and the side regions 32 have different critical current densities. More specifically, the critical current value per unit length in the width direction is higher in the side regions 32 than in the central region 31. That is, the side regions 32 have stronger superconductivity than the central region 31.

The method of producing the superconducting strip 3 in which the central region 31 and the side regions 32 have different critical current densities is not limited to the third example described above. For example, the central portion of the width of the wire layer 30 may be irradiated with an ion beam or an electron beam as in a fourth example described below. In this case, the wire portion irradiated with the ion beam or electron bean is formed as the central region 31 having a lower critical current density than the side regions 32 which are not irradiated with any ion beam or electron beam.

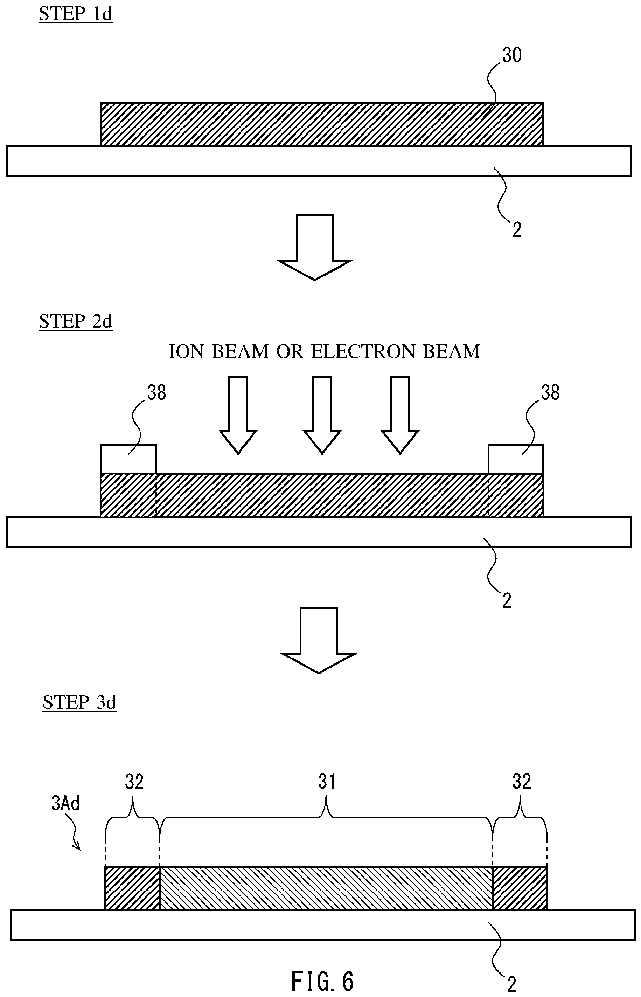

FIG. 6 shows the fourth example of the superconducting strip production method of the present embodiment. Also in FIG. 6, the steps are shown using cross-sectional views perpendicular to the direction in which the bias current flows through the formed superconducting strip 3. First, in step 1d, a wire layer 30 having a given wire shape is formed on a substrate 2 as in the first example. In the present example, the wire layer 30 is made of a material that has a lower critical current density after being irradiated with an ion beam or an electron beam than before the irradiation.

Next, in step 2d, a mask 38 such as a resist is formed on each of the opposite end portions of the width of that region of the wire layer 30 which corresponds to a wire portion 3Ad, and then an ion beam or an electron beam is applied to the surface of the wire layer 30. In step 3d, the mask 38 is removed, and thus the wire portion 3Ad of the superconducting strip 3 is formed. The portion having a lowered critical current density as a result of the irradiation with the ion beam or electron beam is the central region 31, and the portions which are not irradiated with the ion beam or electron beam due to protection by the mask 33 (the portions whose physical properties remain unchanged) are the side regions 32.

The wire portion 3Ad of the present example includes the central region 31 having a first critical current density and the side regions 32 respectively adjacent to the opposite end portions of the width of the central region 31 and having a second critical current density higher than the first critical current density. Thus, even though the central region 31 and the side regions 32 have the same thickness, the critical current value per unit length in the width direction is higher in the side regions 32 than in the central region 31. That is, the side regions 32 have stronger superconductivity than the central region 31.

Superconducting materials that can be used to form the wire layer 30 include a superconducting material that has a higher critical current density after being irradiated with an ion beam or an electron than before the irradiation. In the case of using such a superconducting material, the opposite end portions of the width of the wire portion may be irradiated with an ion beam or an electron beam without irradiation of the central portion of the width of the wire portion to form the side regions 32 having a different critical current density from the central region 31 which is not irradiated with any ion beam or electron beam.

Depending on the type of the superconducting material, the critical current density of the superconducting material can be changed, for example, by irradiation with a radial ray such as X-ray, α-ray, or γ-ray.

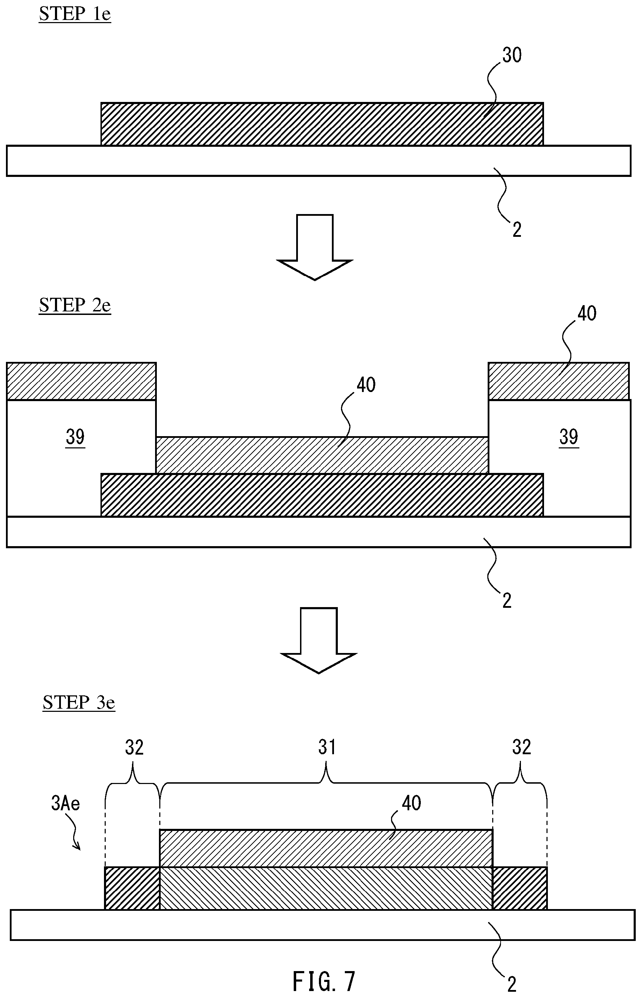

FIG. 7 shows a fifth example of the superconducting strip production method of the present embodiment. Also in FIG. 7, the steps are shown using cross-sectional views perpendicular to the direction in which the bias current flows through the formed superconducting strip 3. First, in step 1e, a wire layer 30 having a given wire shape is formed on a substrate 2 as in the first example.

Next, in step 2e, a mask 39 is formed on the substrate 2 and the wire layer 30, except that region of the wire layer 30 which corresponds to the central region 31 of a wire portion 3Ae, and then a dissimilar material layer 40 made of a non-superconducting material such as a metal or a superconducting material having weaker superconductivity than the wire layer 30 is deposited. The dissimilar material layer 40 of the present example may be made of any material so long as the placement of the dissimilar material layer 40 in contact with or in proximity to the wire layer 30 allows the critical current value per unit length in the width direction to be lower in the wire portion (central region 31) of the wire layer 30 that is in contact with or in proximity to the dissimilar material layer 40 than in the rest (side regions 32) of the wire layer 30.

In step 3e, the mask 39 is removed, and thus the wire portion 3Ae of the superconducting strip 3 is formed. The portion including the dissimilar material layer 40 formed on the wire layer 30 is the central region 31, and the portions on which the dissimilar material layer 40 is not formed due to protection by the mask 39 are the side regions 32. In the wire portion 3Ae of the present example, the central region 31 has a lower critical current density than the side regions 32 due to contact with the dissimilar material layer 40. That is, the side regions 32 have stronger superconductivity than the central region 31.

Another layer may be formed between the dissimilar material layer 40 and the superconducting strip 3. That is, the dissimilar material layer 40 and the superconducting strip 3 need not be in contact and may be located in proximity to each other.

Alternatively, step 2e described above may be replaced with a step in which: a mask 39 is formed on the wire layer 30, except the regions which correspond to the side regions 32 of the wire portion 3Ae; and then a dissimilar material layer made of a superconducting material having stronger superconductivity than the wire layer 30 is deposited. Also in this case, the dissimilar material layer and the superconducting strip may be in contact, or another layer may be formed between the dissimilar material layer and the superconducting strip. In this case, the dissimilar material layer may be made of any material so long as the placement of the dissimilar material layer in contact with or in proximity to the wire layer 30 allows the critical current value per unit length in the width direction to be higher in the wire portion (each side region 32) of the wire layer 30 that is in contact with or in proximity to the dissimilar material layer than in the rest (central region 31) of the wire layer 30.

As described above, the wire portion 3A of the superconducting strip 3, in which the side regions 32 have stronger superconductivity than the central region 31, can be formed by any of various production methods.

Although the foregoing has described an embodiment of the present invention, the present invention is not limited to the embodiment described above, and various modifications, changes, or alterations can be made without departing from the gist of the invention.

For example, although in the above embodiment the superconducting strip 3 (its portion between the electrodes 4 and 5) is illustrated as being formed in a linear shape, the superconducting strip 3 may have any kind of shape such as a linear shape, a meandering shape, or a spiral shape. For example, when the superconducting strip 3 is formed in a meandering shape, linear portions of the superconducting strip 3 may be formed as wire portions 3A each of which includes a central region 31 and side regions 32, or both linear and curved potions of the superconducting strip 3 may be formed as wire portions 3A each of which includes a central region 31 and side regions 32. In addition, the width of the wire portion 3A of the superconducting strip 3 need not be constant. For example, the wire portion 3A may have a width that increases toward the electrodes 4 and 5 and decreases toward the middle point between the electrodes 4 and 5. For example, the opposite end portions of the width of the wire portion 3A may be arc-shaped.

Although in the above embodiment the width of the wire portion 3A is assumed to be from 10 to 15 µm, the wire portion 3A with a width of 10 µm or less or 15 µm or more can be employed, and the employment of such a wire portion 3A also provides the effect as described in the above embodiment. Furthermore, the structure of the wire portion 3A described in the above embodiment is applicable not only to an SMSPD having a width of 1 µm or more but also to an SNSPD having a width of less than 1 µm, and the employment of the wire portion 3A in such a SNSPD also provides the effect as described in the above embodiment.

Although in the above embodiment the critical current value per unit length in the width direction is illustrated as changing discretely (for example, in a stepwise manner) at the boundaries between the central region 31 and the side regions 32, the manner in which the critical current value per unit length in the width direction changes is not limited to that described above. For example, the critical current value per unit length in the width direction may change from the first value Jcc to the second value Jce continuously from the center of the width of the wire portion 3A toward the opposite ends of the width of the wire portion 3A. For example, the wire portion 3A may include: the central region 31 in which the critical current value per unit length in the width direction is the first value Jcc; the side regions 32 in which the critical current value per unit length in the width direction is the second value Jce; and boundary regions that are located between the central region 31 and the side regions 32 and in which the critical current value per unit length in the width direction increases from the first value Jcc toward the second value Jce in the outward direction along their width. In the boundary regions, the critical current value per unit length in the width direction may change stepwise or continuously.

There need not be any clear boundaries between the central region 31 and the side regions 32. In the wire portion 3A, the critical current value per unit length in the width direction may be the first value Jcc which is the minimum in the vicinity of the center of the width of the wire portion 3A and may be the second value Jce which is the maximum in the vicinity of the opposite ends of the width of the wire portion 3A.

The first to fifth examples described as examples of the production method of the wire portion 3A in the above embodiment may be combined in any suitable way. For example, the central region 31 and the side regions 32 may be made of dissimilar materials differing in critical current density and have different thicknesses. In this case, the thickness of the central region 31 may be greater or smaller than the thickness of the side regions 32 so long as the critical current value per unit length in the width direction is higher in the side regions 32 than in the central region 31. In addition, the critical current density of the central region 31 may be higher or lower than the critical current density of the side regions 32 so long as the critical current value per unit length in the width direction is higher in the side regions 32 than in the central region 31.

The materials of the superconducting strip 3 and the substrate 2 are not limited to those in the above embodiment, and various other materials can be used. In addition, one or more other layers may be located between the superconducting strip 3 and the substrate 2, or a structure made of the same or different material from the substrate 2 may be located between the superconducting strip 3 and the substrate 2.

Although in the above embodiment the SSPD 1 which detects single photons is illustrated as the superconducting strip detector to which the present invention is applied, the superconducting strip detector to which the present invention is applicable is not limited to the SSPD 1. The configuration of the superconducting strip 3 of the present invention is applicable to various superconducting strip detectors for detecting various detection targets having a significant energy. Examples of the detection targets include particles or electromagnetic rays such as photons (single photons and multiphotons), electrons, molecules, neutrons, and radial rays. Examples of the radial rays include X-ray, γ-ray, and α-ray.

### [Summary of Disclosure]

Each of the following items is the disclosure of a preferred embodiment.

### [Item 1]

A superconducting strip detector including a superconducting strip located on a detection zone where a detection target having a significant energy is to be detected, wherein the superconducting strip detector detects the detection target in the detection zone by bringing the superconducting strip into a superconducting state and applying a bias current to the superconducting strip through a predetermined bias current path, the superconducting strip includes a wire portion in which a critical current value per unit length in a width direction of the superconducting strip is higher in opposite end portions of a width of the wire portion than in a central portion of the width of the wire portion.

### [Item 2]

The superconducting strip detector according to item 1, wherein the wire portion includes a central region having a first thickness and side regions respectively adjacent to opposite end portions of a width of the central region and having a second thickness greater than the first thickness.

### [Item 3]

The superconducting strip detector according to item 1 or 2, wherein the wire portion includes a central region having a first critical current density and side regions respectively adjacent to opposite end portions of a width of the central region and having a second critical current density different from the first critical current density.

### [Item 4]

The superconducting strip detector according to item 3, wherein the central region is made of a first material having the first critical current density, and the side regions are made of a second material having the second critical current density higher than the first critical current density.

### [Item 5]

The superconducting strip detector according to item 3, wherein the central portion or the opposite end portions of the width of the wire portion have been irradiated with an ion beam or an electron beam.

### [Item 6]

The superconducting strip detector according to any one of items 1 to 5, wherein the wire portion includes: a wire layer; and a dissimilar material layer located in contact with or in proximity to a central portion of a width of the wire layer and made of a non-superconducting material or a superconducting material having weaker superconductivity than the wire layer, or a dissimilar material layer located in contact with or in proximity to opposite end portions of the width of the wire layer and made of a superconducting material having stronger superconductivity than the wire layer.

### [Item 7]

A method of producing a superconducting strip for use in a superconducting strip detector that includes the superconducting strip located on a detection zone where a detection target having a significant energy is to be detected and that detects the detection target in the detection zone by bringing the superconducting strip into a superconducting state and applying a bias current to the superconducting strip through a predetermined bias current path, the method including: forming the superconducting strip such that the superconducting strip includes a wire portion in which a critical current value per unit length in a width direction of the superconducting strip is higher in opposite end portions of a width of the wire portion than in a central portion of the width of the wire portion.

### Reference Signs List

- 1: superconducting single photon detector (superconducting strip detector)
- 3: superconducting strip
- 3A, 3Aa, 3Ab, 3Ac, 3Ad, 3Ae: wire portion
- 30: wire layer
- 31: central region
- 32: side region
- 40: dissimilar material layer
- A: detection zone

## Claims

1. A superconducting strip detector comprising a superconducting strip located on a detection zone where a detection target having a significant energy is to be detected, wherein
the superconducting strip detector detects the detection target in the detection zone by bringing the superconducting strip into a superconducting state and applying a bias current to the superconducting strip through a predetermined bias current path,
the superconducting strip includes a wire portion in which a critical current value per unit length in a width direction of the superconducting strip is higher in opposite end portions of a width of the wire portion than in a central portion of the width of the wire portion.

2. The superconducting strip detector according to claim 1, wherein
the wire portion includes a central region having a first thickness and side regions respectively adjacent to opposite end portions of a width of the central region and having a second thickness greater than the first thickness.

3. The superconducting strip detector according to claim 1 or 2, wherein
the wire portion includes a central region having a first critical current density and side regions respectively adjacent to opposite end portions of a width of the central region and having a second critical current density different from the first critical current density.

4. The superconducting strip detector according to claim 3, wherein
the central region is made of a first material having the first critical current density, and
the side regions are made of a second material having the second critical current density higher than the first critical current density.

5. The superconducting strip detector according to claim 3, wherein
the central portion or the opposite end portions of the width of the wire portion have been irradiated with an ion beam or an electron beam.

6. The superconducting strip detector according to claim 1 or 2, wherein
the wire portion includes:
a wire layer; and
a dissimilar material layer located in contact with or in proximity to a central portion of a width of the wire layer and made of a non-superconducting material or a superconducting material having weaker superconductivity than the wire layer, or a dissimilar material layer located in contact with or in proximity to opposite end portions of the width of the wire layer and made of a superconducting material having stronger superconductivity than the wire layer.

7. A method of producing a superconducting strip for use in a superconducting strip detector that includes the superconducting strip located on a detection zone where a detection target having a significant energy is to be detected and that detects the detection target in the detection zone by bringing the superconducting strip into a superconducting state and applying a bias current to the superconducting strip through a predetermined bias current path, the method comprising:
forming the superconducting strip such that the superconducting strip includes a wire portion in which a critical current value per unit length in a width direction of the superconducting strip is higher in opposite end portions of a width of the wire portion than in a central portion of the width of the wire portion.
